Europäisches Patentamt

European Patent Office

Office européen des brevets

(19)

(11) **EP 0 572 298 B1**

(12) **FASCICULE DE BREVET EUROPEEN**

(45) Date de publication et mention
de la délivrance du brevet:
**25.09.1996 Bulletin 1996/39**

(51) Int Cl.⁶: **H01L 43/06**

(21) Numéro de dépôt: **93401267.5**

(22) Date de dépôt: **18.05.1993**

(54) **Capteur à effet Hall**

Halleffekt-Fühler

Hall effect sensor

(84) Etats contractants désignés:
**AT BE CH DE ES FR GB IE IT LI NL PT SE**

(30) Priorité: **27.05.1992 FR 9206517**

(43) Date de publication de la demande:
**01.12.1993 Bulletin 1993/48**

(73) Titulaire: **SCHLUMBERGER INDUSTRIES S.A.**
**F-92120 Montrouge (FR)**

(72) Inventeurs:
• **Mosser, Vincent**
**F-92350 Le Plessis Robinson (FR)**
• **Robert, Jean-Louis**
**F-34920 Le Cres (FR)**

(74) Mandataire: **Dupont, Henri**
**Schlumberger Industries**
**Centre de Recherches**
**SMR**
**50, Avenue Jean Jaurès**
**B.P. 620-05**
**92542 Montrouge Cédex (FR)**

(56) Documents cités:
**US-A- 4 912 451**

• **PATENT ABSTRACTS OF JAPAN, vol. 12, no.
273 (E-639) 29 Juillet 1988 & JP-A-63 054 785**
• **PATENT ABSTRACTS OF JAPAN, vol. 11, no.
294 (E-544) 22 Septembre 1987 & JP-A-62 093
989**

Printed by Jouve, 75001 PARIS (FR)

## Description

La présente invention a pour objet un capteur à effet Hall. Elle s'applique notamment aux domaines de la mesure des courants électriques et du comptage de l'énergie électrique et plus particulièrement aux compteurs électriques.

On sait qu'un capteur à effet Hall traversé par un courant (ou de manière équivalente soumis à une tension) d'alimentation et soumis à un champ magnétique perpendiculaire à la direction d'écoulement du courant délivre à ses bornes une tension dite de Hall selon une troisième direction de l'espace perpendiculaire aux directions du champ magnétique et d'écoulement du courant.

La tension de Hall $V_H$ est proportionnelle au produit de l'intensité $I_a$ du courant d'alimentation (ou de manière équivalente de l'amplitude de la tension d'alimentation $V_a$) et de l'amplitude du champ magnétique B. Dans un capteur idéal, elle peut donc s'écrire :

$$V_H = K_i.B.I_a = K_v.B.V_a \qquad (1)$$

avec $K_i = 1/(e.n_s)$ où e est la charge de l'électron et $n_s$ est la densité surfacique de porteurs de charge et $K_v = (W/L) \mu$ où W et L sont respectivement la largeur et la longueur du capteur et $\mu$ est la mobilité des porteurs de charge. Dans un capteur à effet Hall réel présentant des inhomogénéités ou un désalignement des électrodes inhérents au procédé de fabrication, la tension de Hall s'écrit:

$$V_H = K_i.I_a.B(1 + f/\mu B) \qquad (2)$$

où le paramètre f, petit devant 1, prend en compte les écarts à la situation idéale.

Pour obtenir une bonne sensibilité, une faible densité surfacique de porteurs est nécessaire.

Ceci peut se faire par exemple en utilisant une structure semiconductrice comportant une couche conductrice homogène, d'épaisseur faible (de l'ordre du micromètre). Cette couche peut-être par exemple une couche de silicium dopée de type n sur un substrat de type P, ou bien une couche de GaAs dopée de type n sur un substrat de GaAs semi-isolant.

Ceci peut également se faire en utilisant une hétérostructure semiconductrice comportant au moins deux couches superposées de matériaux semi-conducteurs ayant une largeur de bande interdite différente, et sélectivement dopée dans le matériau de bande interdite la plus large.

Dans ce cas, les porteurs sont confinés dans une zone très fine (d'épaisseur pouvant aller de 10 à 100 angstroems; 1 angstroem (Å) = 0.1 nm) située à l'interface des deux matériaux, du côté du matériau présentant la bande interdite la moins grande.

Le capteur selon l'invention est de ce second type.

Le document US 4,912,451 décrit une hétérostructure comportant au moins deux puits quantiques : un premier puits quantique formé à l'interface entre deux couches semi-conductrices des largeurs de bande interdite différentes, et dans lequel se trouve le gaz d'électrons bidimensionnel et un second puits quantique dont la "sous-bande" dans son état fondamental présente un niveau d'énergie plus élevé que celui du gaz d'électrons bidimensionnel.

Cette hétérostructure en tant que capteur à effet Hall possède une sensibilité élevée. Elle ne se sature pas, même sous l'effet d'un fort champ électrique et fournit un fort signal de sortie même dans ce cas. Par contre, cette hétérostructure est sensible aux variations de température qui influent sur le signal de sortie. Ce capteur à effet Hall doit être connecté à un dispositif électronique sophistiqué et coûteux pour permettre de compenser la dérive du signal de sortie lorsque la température varie.

L'article intitulé "AlGaAs:GaAs heterojunction Hall device" de T. Taguchi et publié dans Electronics and Communication in Japan, Part 2, Vol. 71, N° 3, 1988 p. 110-115 décrit une hétérojonction simple AlGaAs/GaAs utilisée comme capteur de champ magnétique. Comme précédemment, cette structure, si elle possède une sensibilité accrue ne présente pas de bonnes caractéristiques thermiques. Fabriquée pour fonctionner à température ambiante, elle nécessite un dispositif électronique de compensation si la température présente des variations. A titre indicatif, le coefficient de sensibilité à la température annoncé dans cet article est de 6800 ppm/°C.

Un autre article intitulé "Highly sensitive 2DEG Hall device made of pseudomorphic $In_{0,52}Al_{0,48}As/In_{0,8}Ga_{0,2}As$ heterostructure" rédigé par Sugiyanama et al. et publié dans "International Conférence on Solid-State Sensors and Actuators", Transducers '91, San Francisco, Digest of Technical Papers, IEEE Publications Office décrit une hétérostructure pseudomorphique $In_{0,52}Al_{0,48}As/In_{0,8}Ga_{0,2}As$ déposée sur un substrat en InP. Bien que les performances en fonction de la température soient améliorées par rapport à celles des deux documents précédents, elles restent insuffisantes pour une application à un compteur électrique pour laquelle les spécifications exigées sont très sévères. A titre indicatif, le coefficient de sensibilité à la température d'une telle structure est de 350 ppm/°C sur un intervalle de température n'excédant pas 55°C.

La présente invention a pour but de proposer un capteur à effet Hall présentant une faible sensibilité à la température (coefficient de sensibilité à la température inférieur à 150 ppm/°C) sur une gamme étendue de température (allant au moins de -50°C à + 120°C).

D'autre part, la présente invention a aussi pour but de proposer une structure à effet Hall de forte sensibilité et de faible consommation électrique.

Un autre but de l'invention est de proposer une structure à effet Hall présentant une tension de décalage ("offset" en terminologie anglosaxonne) peu importante, ou en tout cas moins important, à géométrie donnée que pour un capteur selon l'art antérieur.

D'une manière générale, l'invention propose une structure minimisant, de manière notable par rapport à l'art antérieur, les corrections ou autres traitements à apporter à la mesure pour le comptage d'une énergie électrique ou la mesure d'un courant électrique.

De manière plus précise, la présente invention concerne un capteur semi-conducteur à effet Hall comprenant:

Une structure à puits quantique comportant une première couche d'un matériau semi-conducteur III-V, une seconde couche d'un matériau semi-conducteur III-V, et une troisième couche d'un matériau semiconducteur III-V, réalisées par épitaxie sur un substrat semiconducteur, et telle que le matériau de la seconde couche possède une bande interdite plus étroite que celle des matériaux de la première et de la troisième couche, comportant de plus, superposée à la troisième couche, une quatrième couche de matériau semi-conducteur III-V, dite couche d'apport de porteurs, dopée par des impuretés, de type donneur n, d'épaisseur inférieure à 250 angstroems et éventuellement nulle, et dont la densité surfacique de donneurs intégrée sur toute la couche d'apport de porteurs est inférieure à $5 \times 10^{12} cm^{-2}$, et comportant également, superposée à cette couche d'apport de porteurs une cinquième couche de matériau semi-conducteur III-V d'une épaisseur supérieure à 200 angstroems, dite couche d'enfouissement, non-dopée ou dopée par des impuretés de type accepteur, de telle sorte qu'en tout point l'énergie de la bande de conduction de cette couche soit supérieure, par exemple d'au moins 150 meV, à l'énergie de la bande de conduction dans le puits quantique.

Entre le substrat et l'ensemble de couches formant le puits quantique se trouve une couche, dite couche tampon, d'épaisseur totale de l'ordre de quelques milliers d'angstroems, et dont le rôle est d'assurer une bonne planéité et une bonne qualité cristalline des couches épitaxiées ultérieurement.

Cette couche peut être de façon connue soit une couche homogène non-dopée de matériau III-V, soit être elle-même formée par un empilement tel que par exemple un superréseau AlAs/GaAs, soit une combinaison quelconque de couches homogènes et de superréseaux.

Selon un premier mode de réalisation, la structure à puits quantique présente un puits asymétrique: La première couche est en matériau semi-conducteur III-V binaire ou ternaire. La deuxième couche est en matériau semi-conducteur III-V ternaire à plus faible largeur de bande interdite que la première couche, et la troisième couche est en matériau ternaire à plus forte largeur de bande interdite que la deuxième couche. La couche dite d'apport de porteurs étant une couche de matériau ternaire dopé, et la couche d'enfouissement une couche de matériau ternaire à grande largeur de bande interdite ou une couche de matériau ternaire à gradient de composition.

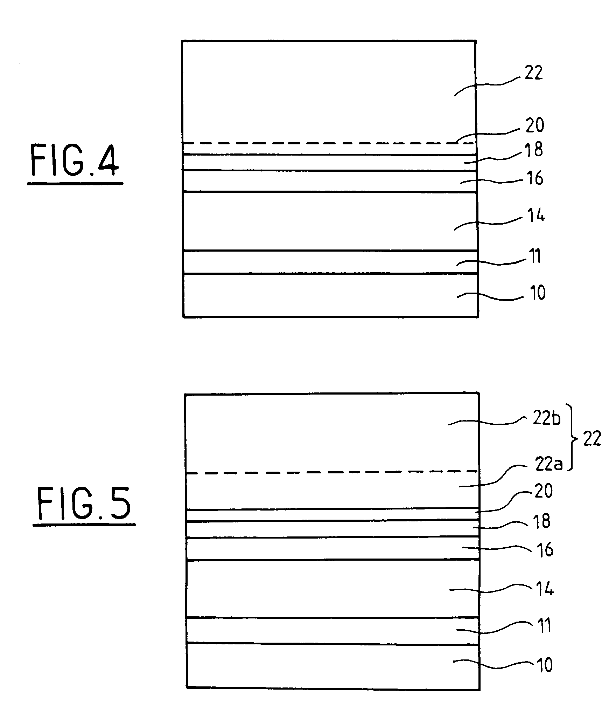

Selon un second mode de réalisation, la structure à puits quantique est symétrique, et comporte de part et d'autre de la deuxième couche en un matériau à plus faible largeur de bande interdite, des première et troisième couches sensiblement identiques en un matériau à plus grande largeur de bande interdite (Figure 3).

Dans ce cas, en plus des couches déjà mentionnées, une autre couche d'apport de porteurs peut être prévue entre la couche-tampon et la structure à puits quantique.

L'invention sera mieux comprise à la lecture de la description qui suit, donnée à titre explicatif et non limitatif en référence aux dessins annexés sur lesquels :

- la figure 1 représente schématiquement une coupe d'un capteur à effet Hall selon l'invention;
- la figure 2 représente schématiquement un diagramme d'énergie de la bande de conduction d'un capteur à effet Hall conforme à l'invention;
- la figure 3 représente schématiquement un diagramme de la bande de conduction d'un capteur conforme au second mode de réalisation;
- la figure 4 représente schématiquement une coupe d'une autre variante de réalisation d'un capteur à effet Hall selon l'invention;
- la figure 5 représente schématiquement une coupe d'une autre variante de réalisation d'un capteur à effet Hall selon l'invention;
- la figure 6 représente schématiquement une coupe d'une autre variante de réalisation d'un capteur selon l'invention.
- la figure 7 représente schématiquement une coupe d'un second mode de réalisation d'un capteur à effet Hall conforme à l'invention;

Un capteur à effet Hall conforme à l'invention comprend un empilement de couches déposées sur un substrat par toute technique connue telle l'épitaxie par jets moléculaires (Molecular Beam Epitaxy en terminologie anglosaxonne) ou l'épitaxie par déposition de vapeur chimique métalloorganique (Metallorganic Chemical Vapor Deposition en terminologie anglosaxonne).

L'homogénéité des couches ainsi que l'uniformité des dopages obtenues par ces techniques sont excellentes, cela permet de diminuer l'offset du capteur à effet Hall lié à ces paramètres.

De cette manière, les opérations de calibration sont simplifiées et le coût des circuits électroniques de compensation sont réduits.

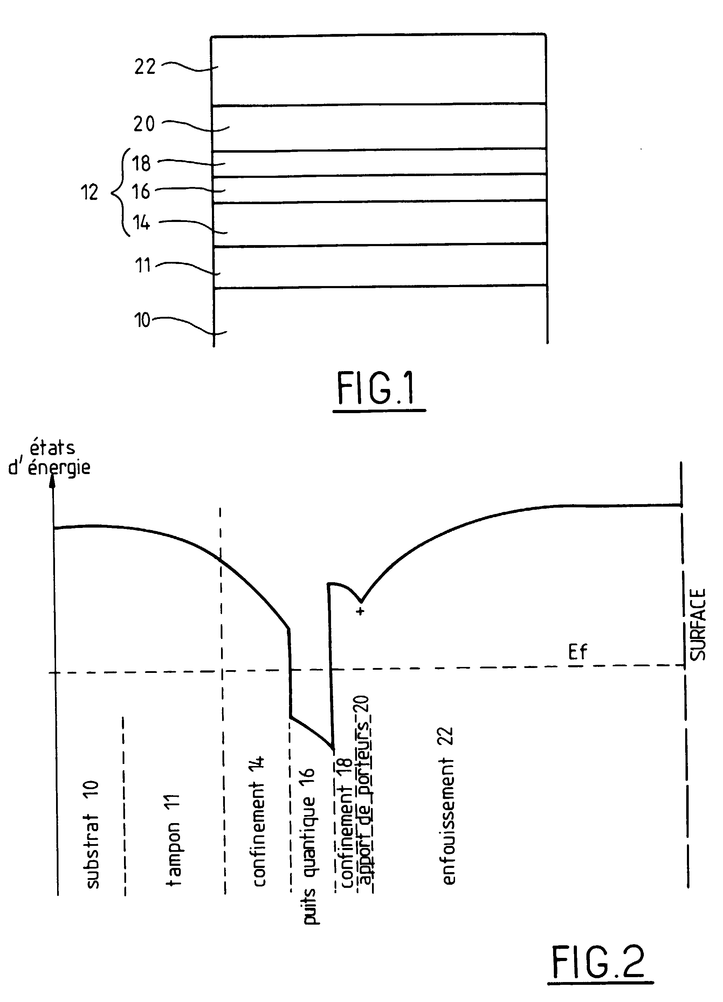

Selon un premier mode de réalisation, représenté schématiquement en coupe sur la figure 1, le capteur comprend un substrat 10 en matériau semi-conducteur sur lequel repose une couche tampon 11, sur laquelle se trouve une structure à puits quantique 12. La couche tampon 11 possède une épaisseur suffisante (au moins égale à 1000 angstroems) pour obtenir une bonne qualité cristalline et une bonne planéité de surface.

La structure 12 est composée d'une première couche dite de confinement 14 en un matériau semiconducteur III-V et déposée sur le substrat, d'une deuxième couche intermédiaire 16 en un matériau semi-conducteur III-V déposée sur la première couche de confinement, d'une troisième couche 18 en un matériau semiconducteur III-V qui est une seconde couche de confinement déposée sur la couche intermédiaire. Un gaz d'électrons bidimensionnel se forme dans le puits quantique.

Les couches de confinement 14, 18 présentent une forte discontinuité de bande de conduction avec la couche semi-conductrice intermédiaire 16 de manière à constituer un puits quantique le plus profond possible au niveau de la couche 16 d'affinité électronique la plus importante.

Une couche 20 dite d'apport de porteurs en matériau semi-conducteur dopé avec un dopant de type n permettant la formation du gaz d'électrons bidimensionnel dans le puits quantique est déposée sur la structure à puits quantique 12. La seconde couche de confinement 18 permet d'éloigner les porteurs formant le gaz bidimensionnel de la zone dopée, ce qui augmente la mobilité des porteurs.

L'augmentation de la mobilité des porteurs diminue la tension de décalage ("offset" en terminologie anglosaxonne) sur la tension de Hall mesurée sur le dispositif pour un courant de polarisation $I_a$ donné.

L'épaisseur de la couche d'apport de porteurs 20 est inférieure à quelques centaines d'angstroems. Elle peut être nominalement nulle, le dopant étant déposé dans l'épaisseur d'un plan atomique d'une couche adjacente selon la technique connue sous le nom de dopage delta.

Le taux de dopage et l'épaisseur sont choisis de telle sorte que la densité surfacique de donneurs intégrée sur toute l'épaisseur de la couche d'apport de porteurs soit comprise dans une gamme allant de $10^{11}cm^{-2}$ à $5.10^{12}cm^{-2}$.

Le nombre de porteurs dans le puits quantique dépend d'une manière connue de la densité surfacique de donneurs intégrée sur toute l'épaisseur de la couche d'apport de porteurs ainsi que des épaisseurs et compositions des différentes couches. Cette densité surfacique de donneurs est par exemple choisie de manière à obtenir une densité surfacique de porteurs dans le puits quantique limitée à quelques $10^{11}cm^{-2}$.

Le coefficient de Hall (équation (I)) est inversement proportionnel à la densité surfacique de porteurs. En limitant cette densité surfacique, on augmente la sensibilité, ce qui permet d'abaisser la puissance de la source d'alimentation nécessaire au fonctionnement du capteur, pour une même tension de Hall délivrée.

Une couche 22 dite d'enfouissement est déposée sur la couche d'apport de porteurs 20; cette dernière couche 22 en matériau à grande largeur de bande interdite forme une zone de charge d'espace dépeuplée de porteurs et donc électriquement isolante. De plus, l'épaisseur de cette couche est choisie dans une gamme allant d'environ 200 angstroems à quelques micromètres.

Or, toute chose étant égale par ailleurs, la dérive thermique de la densité de porteurs (et donc du signal délivré par le capteur) est d'autant plus faible que l'épaisseur d'une telle couche d'enfouissement est importante. L'épaisseur de la couche n'est limitée que par l'apparition de dislocations ou autres défauts.

Avantageusement, l'énergie de la bande de conduction de la couche d'enfouissement 22 est en tout point supérieure d'au moins 150 meV à l'énergie de la bande de conduction dans le puits quantique. De cette manière, le nombre de porteurs présents dans la couche d'enfouissement 22 est négligeable devant le nombre de porteurs dans le puits quantique 16, et ne perturbe donc pas la mesure d'effet Hall.

Après l'achèvement du dépôt des différentes couches décrites ci-dessus, on fabrique un motif de Hall possédant au moins 4 contacts. Le motif de Hall peut être réalisé par gravure sèche ou humide de l'ensemble des couches 11 à 22; des contacts conducteurs sont ensuite formés sur le motif.

On peut également délimiter des zones conductrices en utilisant une technique d'implantation, de manière à rendre non-conducteurs l'ensemble des couches en dehors du motif de Hall. Les contacts ohmiques sont alors réalisés par métallisation pour l'alimentation du dispositif et la mesure de la tension de Hall.

Le dispositif peut être passivé par dépôt d'une couche diélectrique appropriée telle que par exemple $SiO_2$ ou $Si_3N_4$.

La figure 2 représente schématiquement un diagramme d'énergie de la bande de conduction d'un capteur à effet Hall selon le premier mode de réalisation.

La structure à puits quantique 12 à forte discontinuité de bande, telle qu'elle est réalisée par les couches 14, 16, 18 permet d'obtenir un puits profond dans lequel le gaz d'électrons bidimensionnel est bien confiné.

Les atomes dopants de la couche d'apport de porteurs 20 possèdent des états d'énergie non représentés, résonants ou localisés dans la bande interdite, au voisinage de la bande de conduction de la couche. Dans la configuration de l'invention, ces états localisés présentent une énergie supérieure d'au moins 300 meV à celle des électrons du gaz d'électrons bidimensionnel. De cette manière, on évite le phénomène dit de gel des porteurs qui correspond à une non ionisation des atomes dopants. Or la proportion de porteurs gelés sur ces états localisés varie en fonction de la température. Empêcher l'apparition de ce phénomène permet donc d'éviter une source de dérive du signal de Hall avec la température.

Le premier mode de réalisation se rapportant aux figures 1 et 2 va être décrit avec plus de détails dans les exemples suivants cités à titre indicatif et non limitatif.

EXEMPLE 1:

Le substrat 10 est en GaAs; la couche de tampon 11 peut être alors choisie parmi une couche de GaAs, une couche formée par un superréseau AlAs/GaAs ou encore une couche formée par la superposition de GaAs déposée sur le substrat et d'une couche formée par un superréseau AlAs/GaAs.

La première couche de confinement 14 peut être une couche de GaAs non dopé. En variante, cette couche peut être éventuellement confondue avec la couche tampon 11 qui remplit alors les deux fonctions de tampon et de confinement. Son épaisseur est comprise entre 0 et quelques milliers d'angstroems.

La couche semi-conductrice intermédiaire 16 est en $In_xGa_{1-x}As$ non dopé, avec une composition x comprise dans une gamme allant de 0 à 1, préférentiellement allant de 0 à 0,4 et par exemple égale à 0,15. Son épaisseur est comprise dans une gamme allant de 10 angstroems à 500 angstroems, par exemple 130 Å.

La troisième couche 18 dite de confinement est en $Al_yGa_{1-y}As$ non dopé de composition y compris dans une gamme allant de 0 à 0,4; y peut être par exemple égale à 0,32. L'épaisseur de la couche 18 est inférieure à 200 angstroems. Elle peut être par exemple de 40 Å.

En variante, la troisième couche 18 de confinement est formée par un superréseau à courte période AlAs/GaAs, par exemple du type n/m, n représentant le nombre de couches atomiques d'AlAs et m représentant le nombre de couches atomiques de GaAs. Si n et m sont assez petits, par exemple compris entre 1 et 10, ce superréseau AlAs/GaAs n/m a des propriétés électriques très proches de celles de l'alliage désordonné $Al_yGa_{1-y}As$, avec y=n/(n+m), et est appelé pseudoalliage.

La couche d'apport de porteurs 20 est en $Al_uGa_{1-u}As$ dopé avec un dopant de type n choisi parmi les éléments des colonnes IV (par exemple Si, Ge, Sn) ou VI (par exemple S, Se, Te) du tableau périodique. Avantageusement, lorsqu'on utilise la technique d'épitaxie par jets moléculaires, on choisit le silicium comme dopant.

Le taux de dopage est choisi de sorte que la densité surfacique d'atomes dopants intégrée sur toute l'épaisseur de la couche d'apport de porteurs soit comprise entre $10^{11}cm^{-2}$ et $10^{12}cm^{-2}$. La densité surfacique de donneurs peut être par exemple de $10^{12}cm^{-2}$.

La composition u est comprise dans une gamme allant de 0 à 0,4 ; elle peut être par exemple de 0,32.

L'épaisseur de la couche d'apport de porteurs est inférieure à quelques centaines d'angstroems ; elle peut être par exemple de 40 Å.

Selon une variante de réalisation représentée schématiquement en coupe sur la figure 4, la couche 20 est d'épaisseur nominalement nulle ; le dopant, formant seul la couche, est représenté en pointillés. Le dépôt du dopant est effectué dans l'épaisseur d'un plan atomique de la seconde couche de confinement 18 selon la technique connue sous le nom de "dopage delta".

L'utilisation d'une couche de porteurs d'épaisseur très faible, et plus encore l'utilisation du dopage delta, permet de minimiser le piégeage des porteurs sur les états localisés des atomes dopants, et par conséquence d'obtenir une faible dérive thermique du coefficient de Hall.

Selon une variante de réalisation, la couche d'apport de porteurs 20 est réalisée par un superréseau à courte période en AlAs/GaAs formant un pseudo-alliage (le superréseau peut être du type n/2n avec n représentant le nombre de couches atomiques et n étant compris entre 1 et 10).

La couche d'enfouissement 22 est en $Al_qGa_{1-q}As$ non dopé de composition q comprise dans une gamme allant de 0 à 0,4 et par exemple égale à 0,32.

L'épaisseur de la couche d'enfouissement 22 est comprise dans une gamme allant de 200 angstroems à 2 microns; elle peut être par exemple de 3000 Å.

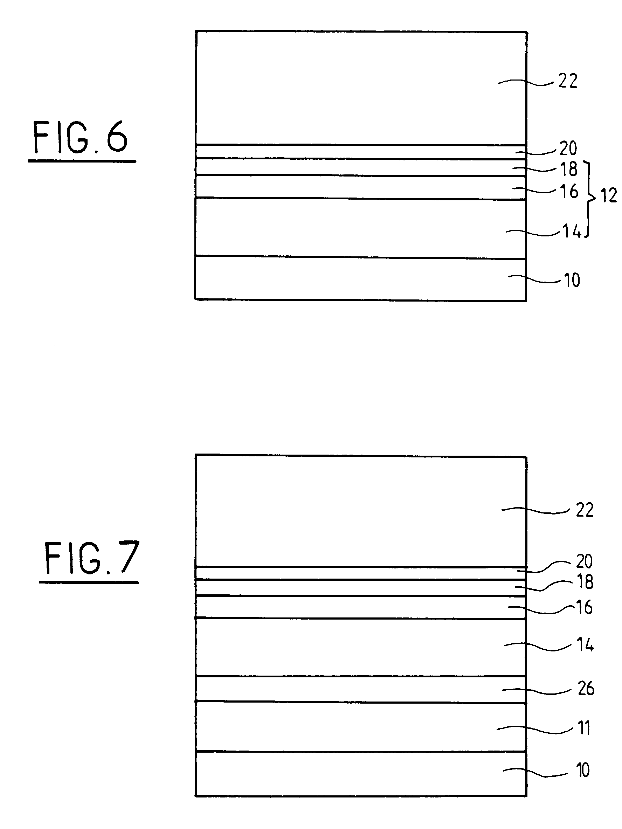

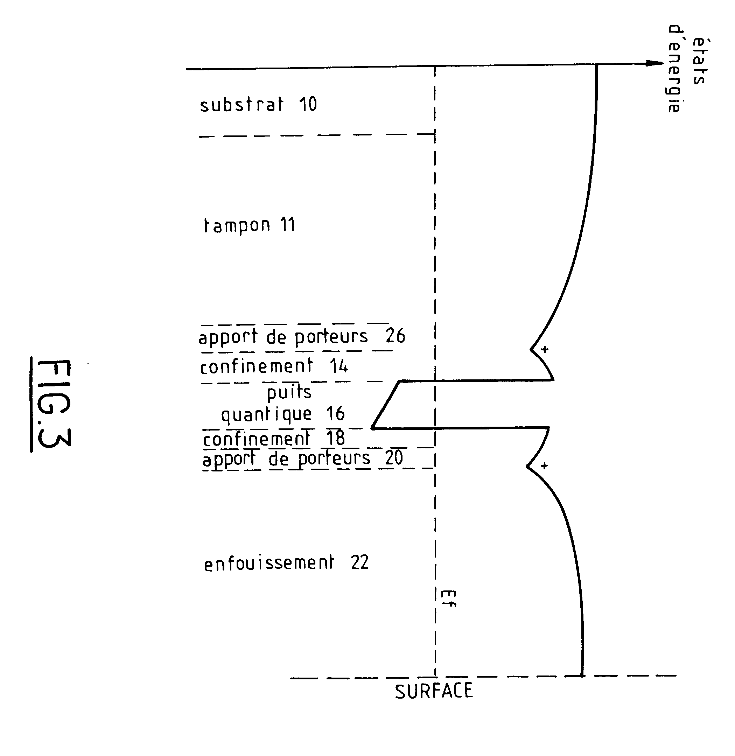

Selon une variante de réalisation représentée schématiquement en coupe sur la figure 5, pour éviter tout dopage résiduel de type p pouvant survenir dans une couche trop épaisse, la couche d'enfouissement 22 est formée par une première couche 22a en $Al_pGa_{1-p}As$ ayant une composition p comprise dans une gamme allant de O à 0,4 et par exemple égale à 0,32.

L'épaisseur de cette première couche 22a est comprise dans une gamme allant de 200 angstroems à quelques milliers d'angstroems; elle peut être par exemple de 500 Å.

Une seconde couche 22b en $Al_wGa_{1-w}As$ possédant un gradient de composition, c'est à dire que w varie de la composition de la couche précédente 22a à 0. De cette manière, la transition est assurée vers une couche de GaAs dont le dopage résiduel est beaucoup mieux contrôlé lors d'un dépôt par épitaxie par jets moléculaires ou par MOCVD.

L'épaisseur de la couche 22b est comprise dans une gamme allant de 0 à 2 micromètres et est par exemple égale à 2500 angstroems.

La couche 22 d'enfouissement peut aussi être formée par un superréseau à courte période AlAs/GaAs (du même type que les superréseaux précédemment cités) formant un pseudo alliage.

EXEMPLE 2

Dans cet exemple, le substrat est en silicium. La première couche de confinement 14 jouant le rôle de tampon est par exemple, un superréseau AlAs/GaAs qui assure la relaxation des contraintes dues à la différence de paramètres de maille des cristaux de Si d'une part et de GaAs ou AlAs d'autre part.

D'une manière générale, le superréseau peut être du type $Al_zGa_{1-z}As/GaAs$ avec la composition z comprise dans une gamme allant de 0 à 1. Le reste de la structure peut être identique à ce qui a été décrit pour l'EXEMPLE 1.

EXEMPLE 3

Le substrat est en InP. La couche tampon 11 est par exemple une couche d'InP. Son épaisseur peut prendre les mêmes valeurs que la couche tampon 11 de l'EXEMPLE 1. La couche tampon 11 est en InGaAs.
Dans une variante de réalisation, la couche tampon 11 peut aussi être un superréseau du type InGaAs/InAlAs ou encore être composé d'une couche InP recouverte par un superréseau du type InGaAs/InAlAs.

La première couche de confinement 14 est une couche d'InP non dopée. La couche semiconductrice intermédiaire 16 est en $In_xGa_{1-x}As$ adaptée en paramètre de maille avec InP, c'est à dire avec une composition x comprise dans une gamme allant de 0,5 à 0,56 et par exemple voisine de 0,53. La seconde couche de confinement 18 est une couche d'$In_yAl_{1-y}As$ également adaptée en paramètre de maille avec InP, c'est à dire avec une composition y comprise dans une gamme allant de 0,5 à 0,56 et par exemple voisine de 0,52.

La couche d'apport de porteurs 20 et la couche d'enfouissement 22 sont en $In_iAl_{1-i}As$ avec une composition i comprise dans une gamme allant de 0,5 à 0,56 par exemple 0,52.
Les épaisseurs de chacune de ces couches sont du même ordre que celles de l'EXEMPLE 1; ainsi, dans une variante, la couche d'apport de porteurs 20 peut être d'épaisseur nominalement nulle par "dopage delta".

On décrit maintenant un second mode de réalisation en référence aux figures 6 et 7 représentant de manière schématique respectivement une coupe d'un capteur à effet Hall selon ce mode de réalisation et les états d'énergie de la bande de conduction correspondante.
Les références identiques à celles des figures précédentes désignent le même type de couche.
Ainsi, les couches sont déposées sur un substrat 10 en un matérieu choisi parmi GaAs, InP, Si de manière similaire aux exemples précédents. On retrouve dans ce mode de réalisation la couche tampon 11, la structure à puits quantique formée par les couches 14, 16,18, la couche d'apport de porteurs 20 et la couche d'enfouissement 22 réalisées de manière similaire aux exemples précédents.
Comme on peut le voir sur les figures 6 et 7, le capteur à effet Hall possède une structure symétrique. La couche tampon 11, de même que dans les exemples précédents, permet d'obtenir un bon état de surface et l'adaptation des paramètres de maille entre les matériaux de la couche 10 (substrat) et la couche suivante 26 qui est une couche d'apport de porteurs identique à la couche 20.

Grâce à sa structure particulière, un capteur à effet Hall conforme à l'invention possède une faible sensibilité en température (inférieure à 150 ppm/°C) sur une gamme étendue de température allant au moins de -50°C à + 120°C. De plus, la mobilité μ des porteurs dans le puits quantique est très élevée (μ est supérieure à 7000 cm$^2$/V.s), ce qui pour une géométrie de capteur donnée, diminue fortement la tension de décalage ("offset" en terminologie anglosaxonne) (on peut comparer avec un dispositif en silicium conforme à l'art antérieur pour lequel μ ≤1400 cm$^2$/V.S). On comprend donc que pour une application au comptage de l'énergie électrique ou à la mesure de courants électriques, un capteur selon l'invention ne nécessite pas de circuit de compensation ce qui facilite la réalisation du compteur et diminue son coût.

**Revendications**

1. Capteur semiconducteur à effet Hall comprenant une structure à puits quantique comportant une première couche (14) d'un matériau semiconducteur III-V, une seconde couche (16) d'un matériau semiconducteur III-V, et une troisième couche (18) d'un matériau semiconducteur III-V, déposée sur un substrat semiconducteur, et telle que le matériau de la seconde couche (16) possède une bande interdite plus étroite que celle des matériaux de la première et de la troisième couche (14, 18), comportant de plus, superposée à la troisième couche (18) une quatrième couche (20) dite couche d'apport de porteurs, dopée par des impuretés de type donneur, d'épaisseur inférieure à 25 nm (250 angstroems), et dont la densité surfacique de donneurs intégrés sur toute l'épaisseur de la couche d'apport de porteurs est inférieure à 5x10$^{12}$cm$^{-2}$, et comportant également, superposée à cette couche d'apport de porteurs une cinquième couche (22) de matériau semiconducteur III-V d'une épaisseur supérieure à 20 nm (200 angstroems), dite couche d'enfouissement, non dopée ou dopée par des impuretés de type accepteur, de telle sorte que la bande de conduction de cette couche (22) soit en tout point d'énergie supérieure à l'énergie de la bande de conduction de la seconde couche (16).

2. Capteur selon la revendication 1, caractérisé en ce que la structure à puits quantique (12) comprend : une première couche (14) en matériau semiconducteur III-V, une deuxième couche (16) en matériau semiconducteur III-V ayant une bande interdite de plus faible largeur que la bande interdite de la première couche (14), une troisième couche (18) en matériau semiconducteur III-V ayant une bande interdite de plus grande largeur que la bande interdite de la première couche (14).

3. Capteur à semiconducteur selon la revendication 1, caractérisé en ce que la première couche (14) en matériau semiconducteur III-V est une couche de confinement réalisant une fonction de tampon entre le substrat (10) et la structure à puits quantique (12).

4. Capteur selon la revendication 1, caractérisé en ce que la quatrième couche (20) dite d'apport de porteurs présente une épaisseur nominalement nulle, le dopant étant déposé dans l'épaisseur d'un plan atomique d'une couche adjacente à la couche d'apport de porteurs.

5. Capteur selon la revendication 1, caractérisé en ce que le substrat est en un matériau choisi parmi Si, GaAs.

6. Capteur selon la revendication 5 caractérisé en ce que la seconde couche (16) est en $In_xGa_{1-x}As$ avec une composition x comprise dans une gamme allant de 0 à 0,4 et une épaisseur comprise dans une gamme allant de 1 nm à 50 nm (10 angstroems à 500 angstroems).

7. Capteur selon la revendication 5 caractérisé en ce que la troisième couche (18) est en $Al_yGa_{1-y}As$ avec une composition y comprise dans une gamme allant de 0 à 0,4 et une épaisseur inférieure à 20 nm (200 angstroems).

8. Capteur selon la revendication 5 caractérisé en ce que la troisième couche (18) est formée par un superréseau à courte période AlAs/GaAs formant un pseudoalliage.

9. Capteur selon la revendication 5 caractérisé en ce que la quatrième couche (20) d'apport de porteurs est en $Al_\mu Ga_{1-\mu}As$ avec une composition $\mu$ comprise dans une gamme allant de 0 et 0,4, la couche d'apport de porteurs étant dopée avec un dopant de type n appartenant à une colonne du tableau périodique choisie parmi les colonnes IV et VI.

10. Capteur selon la revendication 5, caractérisé en ce que la quatrième couche (20) dite d'apport de porteurs est formée par un superréseau à courte période AlAs/GaAs formant un pseudoalliage, la couche d'apport de porteurs étant dopée avec un dopant de type du tableau périodique choisie parmi les colonnes IV et VI.

11. Capteur selon la revendication 5 caractérisé en ce que la cinquième couche (22) dite d'enfouissement est en $Al_\mu Ga_{1-\mu}As$ avec une composition $\mu$ comprise dans une gamme allant de 0 à 0,4.

12. Capteur selon la revendication 5 caractérisé en ce que la cinquième couche (22) dite d'enfouissement est formée par un superréseau à courte période en AlAs/GaAs formant un pseudoalliage.

13. Capteur selon la revendication 5 caractérisé en ce que la cinquième couche (22) dite d'enfouissement est une structure comprenant une première couche (22a) en alliage ou pseudoalliage $Al_pGa_{1-p}As$ ayant

une composition p comprise dans une gamme allant de 0 à 0,4 et une seconde couche (22b) en $Al_wGa_{1-w}As$ possédant un gradient de composition, w allant de p à zéro.

14. Capteur selon la revendication 1, caractérisé en ce que le substrat est en InP.

15. Capteur selon la revendication 14 caractérisé en ce que la seconde couche (16) est en $In_xGa_{1-x}As$ avec une composition x comprise entre 0,5 et 0,56 et une épaisseur comprise dans une gamme allant de 1 nm à 50 nm (10 Angstroems à 500 Angstroems).

16. Capteur selon la revendication 15 caractérisé en ce que la troisième couche (18) est $In_yAl_{1-y}As$ avec une composition y comprise dans une gamme allant de 0,5 à 0,56 et une épaisseur inférieure à 20 nm (200 Angstroems).

17. Capteur selon la revendication 14 caractérisé en ce que la quatrième couche (20) dite d'apport de porteurs est en $In_vAl_{1-v}As$ avec une composition v comprise dans une gamme allant de 0,5 à 0,56, la couche d'apport de porteurs étant dopée avec un dopant de type n appartenant à une colonne du tableau périodique choisie parmi les colonnes IV et VI.

18. Capteur selon la revendication 15 caractérisé en ce que la cinquième couche (22) dite d'enfouissement est en $In_zAl_{1-z}A_z$ avec une composition z allant de 0,5 à 0,56.

19. Capteur selon la revendication 1, caractérisé en ce qu'il comprend en outre, symétriquement à la couche (20) d'apport de porteurs, une seconde couche (26) d'apport de porteurs adjacente à la structure à puits quantique (12).

**Patentansprüche**

1. Halbleiter-Meßwertaufnehmer mit Halleffekt, der eine Quantentopf-Struktur besitzt, die versehen ist mit einer ersten Schicht (14) aus einem III-V-Halbleitermaterial, einer zweiten Schicht (16) aus einem III-V-Halbleitermaterial und einer dritten Schicht (18) aus einem III-V-Halbleitermaterial und auf einem Halbleitersubstrat aufgebracht ist, derart, daß das Material der zweiten Schicht (16) ein schmaleres verbotenes Band als die Materialien der ersten und der dritten Schicht (14, 18) besitzt, und die ferner versehen ist mit einer der dritten Schicht (18) überlagerten vierten Schicht (20), die Trägerzufuhrschicht genannt wird und mit Störstellen des Donatortyps dotiert ist, eine Dicke von weniger als 25 nm (250 Ångström) besitzt und eine Oberflächendichte der in der gesamten Dicke der Trägerzufuhrschicht integrierten Donatoren besitzt, die kleiner als $5 \cdot 10^{12}$ cm$^{-2}$ ist, und außerdem versehen ist mit einer dieser Trägerzufuhrschicht überlagerten fünften Schicht (22) aus III-V-Halbleitermaterial mit einer Dicke von mehr als 20 nm (200 Ångström), die Vergrabungsschicht genannt wird und mit Störstellen des Akzeptortyps dotiert oder nicht dotiert ist, derart, daß das Leitungsband dieser Schicht (22) an jedem Punkt eine Energie besitzt, die höher als die Energie des Leitungsbandes der zweiten Schicht (16) ist.

2. Meßwertaufnehmer nach Anspruch 1, dadurch gekennzeichnet, daß die Quantentopf-Struktur (12) enthält:
eine erste Schicht (14) aus III-V-Halbleitermaterial, eine zweite Schicht (16) aus III-V-Halbleitermaterial, die ein verbotenes Band besitzt, dessen Breite geringer als diejenige des verbotenen Bandes der ersten Schicht (14) ist, und eine dritte Schicht (18) aus III-V-Halbleitermaterial, die ein verbotenes Band mit einer Breite besitzt, die größer als diejenige des verbotenen Bandes der ersten Schicht (14) ist.

3. Halbleiter-Meßwertaufnehmer nach Anspruch 1, dadurch gekennzeichnet, daß die erste Schicht (14) aus III-V-Halbleitermaterial eine Einschlußschicht ist, die eine Pufferfunktion zwischen dem Substrat (10) und der Quantentopf-Struktur (12) verwirklicht.

4. Meßwertaufnehmer nach Anspruch 1, dadurch gekennzeichnet, daß die vierte sogenannte Trägerzufuhrschicht (20) eine Nenndicke Null aufweist, wobei das Dotierungsmittel in die Dicke einer atomaren Ebene einer an die Trägerzufuhrschicht angrenzenden Schicht eingebracht wird.

5. Meßwertaufnehmer nach Anspruch 1, dadurch gekennzeichnet, daß das Substrat ein Material ist, das aus Si, GaAs ausgewählt ist.

6. Meßwertaufnehmer nach Anspruch 5, dadurch gekennzeichnet, daß die zweite Schicht (16) aus $In_xGa_{1-x}AS$ besteht, mit einer Zusammensetzung x, die in einem Bereich von 0 bis 0,4 liegt, und einer Dicke, die in einem Bereich von 1 nm bis 50 nm (10 Ångström bis 500 Ångström) liegt.

7. Meßwertaufnehmer nach Anspruch 5, dadurch gekennzeichnet, daß die dritte Schicht (18) aus $Al_yGa_{1-y}As$ besteht, mit einer Zusammensetzung y, die in einem Bereich von 0 bis 0,4 liegt, und einer Dicke, die kleiner als 20 nm (200 Ångström) ist.

8. Meßwertaufnehmer nach Anspruch 5, dadurch gekennzeichnet, daß die dritte Schicht (18) durch ein AlAs/GaAs-Übergitter mit kurzer Periode gebildet ist, das eine Pseudolegierung bildet.

9. Meßwertaufnehmer nach Anspruch 5, dadurch gekennzeichnet, daß die vierte Trägerzufuhrschicht (20) aus $Al_\mu Ga_{1-\mu}As$ besteht, mit einer Zusammensetzung $\mu$, die in einen Bereich von 0 bis 0,4 liegt, wobei die Trägerzufuhrschicht mit einem Dotierungsmittel des Typs n dotiert ist, das zu einer Spalte des Periodensystems gehört, die aus den Gruppen IV und VI ausgewählt ist.

10. Meßwertaufnehmer nach Anspruch 5, dadurch gekennzeichnet, daß die vierte sogenannte Trägerzufuhrschicht (20) durch ein AlAs/GaAs-Übergitter mit kurzer Periode gebildet ist, das eine Pseudolegierung bildet, wobei die Trägerzufuhrschicht mit einem Dotierungsmittel des aus den Gruppen IV und VI des Periodensystems gewählten Typs dotiert ist.

11. Meßwertaufnehmer nach Anspruch 5, dadurch gekennzeichnet, daß die fünfte sogenannte Vergrabungsschicht (22) aus $Al_\mu Ga_{1-\mu}As$ besteht, mit einer Zusammensetzung $\mu$, die in einem Bereich von 0 bis 0,4 liegt.

12. Meßwertaufnehmer nach Anspruch 5, dadurch gekennzeichnet, daß die fünfte sogenannte Vergrabungsschicht (22) durch ein AlAs/GaAs-Übergitter mit kurzer Periode aus gebildet ist, das eine Pseudolegierung bildet.

13. Meßwertaufnehmer nach Anspruch 5, dadurch gekennzeichnet, daß die fünfte sogenannte Vergrabungsschicht eine Struktur ist, die versehen ist mit einer ersten Schicht (22a) aus einer Legierung oder einer Pseudolegierung $Al_pGa_{1-p}As$, die eine Zusammensetzung p besitzt, die in einem Bereich von 0 bis 0,4 liegt, und einer zweiten Schicht (22b) aus $Al_wGa_{1-w}As$, die einen Zusammensetzungsgradienten besitzt, wobei w im Bereich von p bis Null liegt.

14. Meßwertaufnehmer nach Anspruch 1, dadurch gekennzeichnet, daß das Substrat aus InP besteht.

15. Meßwertaufnehmer nach Anspruch 14, dadurch gekennzeichnet, daß die zweite Schicht (16) aus $In_xGa_{1-x}As$ besteht, mit einer Zusammensetzung x, die zwischen 0,5 und 0,56 liegt, und einer Dicke, die in einem Bereich von 1 nm bis 50 nm (10 Ångström bis 500 Ångström) liegt.

16. Meßwertaufnehmer nach Anspruch 15, dadurch gekennzeichnet, daß die dritte Schicht (18) $In_yAl_{1-y}As$ ist, mit einer Zusammensetzung y, die in einem Bereich von 0,5 bis 0,56 liegt, und einer Dicke, die kleiner als 20 nm (200 Ångström) ist.

17. Meßwertaufnehmer nach Anspruch 14, dadurch gekennzeichnet, daß die vierte sogenannte Trägerzufuhrschicht (20) aus $In_vAl_{1-v}As$ besteht, mit einer Zusammensetzung v, die in einem Bereich von 0,5 bis 0,56 liegt, wobei die Trägerzufuhrschicht mit einem Dotierungsmittel des Typs n dotiert ist, das zu einer Spalte des Periodensystems gehört, die aus den Gruppen IV und VI gewählt ist.

18. Meßwertaufnehmer nach Anspruch 15, dadurch gekennzeichnet, daß die fünfte sogenannte Vergrabungsschicht (22) aus $In_zAl_{1-z}A_z$ besteht, mit einer Zusammensetzung z, die von 0,5 bis 0,56 läuft.

19. Meßwertaufnehmer nach Anspruch 1, dadurch gekennzeichnet, daß er außerdem symmetrisch zur Trägerzufuhrschicht (20) eine zweite Trägerzufuhrschicht (26) enthält, die an die Quantentopf-Struktur (12) angrenzt.

**Claims**

1. A Hall effect semiconductor sensor comprising a quantum well structure having a first layer (14) of a III-V semiconductor material, a second layer (16) of a III-V semiconductor material, and a third layer (18) of a III-V semiconductor material deposited on a semiconductor substrate, and such that the material of the second layer (16) has a forbidden band narrower than that of the materials of the first and third layers (14, 18), further including, superimposed on the third layer (18), a fourth layer (20) referred to as the carrier injection layer, doped with donor type impurities, of thickness less than 25 nm (250 Å), and whose donor density per unit area integrated over the whole carrier injection layer is less than $5 \times 10^{12} cm^{-2}$, and also including, superimposed on this carrier injection layer, a fifth layer (22) of III-V semiconductor material with a thickness greater than 20 nm (200 Å), called the burial layer, which is not doped or which is doped with acceptor type impurities, such that the conduction band of this layer (22) shall always have higher energy than the energy of the conduction band of the second layer (16).

2. A sensor according to claim 1, characterized in that the quantum well structure (12) comprises:
a first layer (14) of III-V semiconductor material, a second layer (16) of III-V semiconductor material having a forbidden band of smaller width than the forbidden band of the first layer (14) and a third layer (18) of III-V semiconductor material having a forbidden band of greater width than the forbidden band of the first layer (14).

3. A sensor according to claim 1, characterized in that the first layer (14) of III-V semiconductor material is a confining layer providing a buffer function between the substrate (10) and the quantum well structure (12).

4. A sensor according to claim 1, characterized in that the fourth layer (20) called the carrier injection layer has a thickness which is nominally zero, the dopant being deposited in the thickness of an atomic plane of a layer adjacent to the carrier injection layer.

5. A sensor according to claim 1, characterized in that the substrate is a material selected from Si and GaAs.

6. A sensor according to claim 5, characterized in that the second layer (16) is of $In_xGa_{1-x}As$ with a value of $\underline{x}$ in a range from 0 to 0.4 and a thickness in range from 1 nm to 50 nm (10 Å to 500 Å).

7. A sensor according to claim 5, characterized in that the third layer (18) is of $Al_yGa_{1-y}As$ with a value of $\underline{y}$ in a range from 0 to 0.4 and a thickness less than 20 nm (200 Å).

8. A sensor according to claim 5, characterized in that the third layer (18) is formed by a AlAs/GaAs superlattice with a short period forming a pseudo-alloy.

9. A sensor according to claim 5, characterized in that the fourth carrier injection layer (20) is of $Al_\mu Ga_{1-\mu}As$ with a value of $\underline{\mu}$ in a range from 0 to 0.4, the carrier injection layer being doped with an n-type dopant pertaining to a group of the periodic table selected from groups IV and VI.

10. A sensor according to claim 5, characterized in that the fourth layer (20) called the carrier injection layer is formed by an AlAs/GaAs superlattice with a short period forming a pseudo-alloy, the carrier injection layer being doped with a n-type dopant of the periodic table selected from groups IV and VI.

11. A sensor according to claim 5, characterized in that the fifth layer (22) called the burial layer is of $Al_\mu Ga_{1-\mu}As$ with a value of $\underline{\mu}$ in a range from 0 to 0.4.

12. A sensor according to claim 5, characterized in that the fifth layer (22) called the burial layer is formed by an AlAs/GaAs superlattice with a short period forming a pseudo-alloy.

13. A sensor according to claim 5, characterized in that the fifth layer (22) called the burial layer is a structure comprising a first layer (22a) of an alloy or pseudo-alloy of $Al_pGa_{1-p}As$ with a value of p in a range from 0 to 0.4 and a second layer (22b) of $Al_wGa_{1-w}As$ having a composition gradient, w going

from $\underline{p}$ to zero.

14. A sensor according to claim 1, characterized in that the substrate is of InP.

15. A sensor according to claim 14, characterized in that the second layer (16) is of $In_xGa_{1-x}As$ with a value of $\underline{x}$ from 0.5 to 0.56 and a thickness in a range from 1 nm to 50 nm (10 Å to 500 Å).

16. A sensor according to claim 15, characterized in that the third layer (18) is of $In_yAl_{1-y}As$ with a value of $\underline{y}$ from 0.5 to 0.56 and a thickness less than 20 nm (200 Å).

17. A sensor according to claim 14, characterized in that the fourth layer (20) called the carrier injection layer is formed of $In_vAl_{1-v}As$ with the value of $\underline{v}$ in a range from 0.5 to 0.56, the carrier injection layer being doped with an n-type dopant pertaining to a group of the periodic table selected from groups IV and VI.

18. A sensor according to claim 15, characterized in that the fifth layer (22) called the burial layer is of $In_zAl_{1-z}A_z$ with the value of $\underline{z}$ from 0.5 to 0.56.

19. A sensor according to claim 1, characterized in that it further comprises, symmetrical with the carrier injection layer (20), a second carrier injection layer (26) adjacent to the quantum well structure (12).

22

20

18
16     12
14

11

10

## FIG.1

états
d'énergie

+

Ef

SURFACE

substrat 10

tampon 11

confinement 14

puits quantique 16

confinement 18
apport de porteurs 20

enfouissement 22

## FIG.2

FIG.4

22
20
18
16
14
11
10

FIG.5

22b
22
22a
20
18
16
14
11
10

FIG.6

22

20
18
16 } 12
14

10

FIG.7

22

20
18
16

14

26

11

10

états
d'energie

+          +

Ef

SURFACE

apport de porteurs 26

confinement 14

puits
quantique 16

confinement 18

apport de porteurs 20

enfouissement 22

substrat 10

tampon 11

FIG.3